# EUROPEAN PATENT APPLICATION

(11) **EP 4 362 081 A1**
(43) Date of publication of application: **01.05.2024**
(21) Application number: 23196173.1
(22) Date of filing: 08.09.2023
(51) Int. Cl.: H01L 23/427, H01L 23/367

(54) **HEAT SINK AND ELECTRONIC DEVICE**

(30) Priority: 31.10.2022 TW 111141297
(71) Applicant: Giga Computing Technology Co., Ltd., New Taipei City 231 (TW)
(72) Inventor: Lin, Jian-Hung, 231 New Taipei City (TW); Huang, Ching-Chuan, 231 New Taipei City (TW); Adachi, Nobuhiro, 231 New Taipei City (TW)
(74) Representative: Kurig, Thomas

(57) **Abstract**

A heat sink (3) and an electronic device (1) are provided. The electronic device (1) includes a circuit board (2) having a heat source (21), and a heat sink (3) contacting the heat source (21) to dissipate the heat. The heat sink (3) includes a heat dissipating plate (31) having an inlet region (IR), an outlet region (OR) and a vaporization region (VR) therebetween, and a cover plate (32). The vaporization region (VR) is disposed corresponding to the heat source (21). The cover plate (32) covers on the heat dissipating plate (31), and a channel (C) with an inlet (C1) and an outlet (C2) is formed between the cover plate (32) and the heat dissipating plate (31). A cooling liquid flowing into the channel (C) from the inlet (C1) is vaporized to a gas in the vaporization region (VR), and then dissipates outside the channel (C) through the outlet (C2).

## Description

### BACKGROUND

### Technical Field

The disclosure relates to a component and device, and more particularly, to a heat sink and an electronic device.

### Description of Related Art

In the two-phase immersion heat dissipation mechanism, the electronic components to be dissipated need to rely on the latent heat change of the phase change of the immersion liquid to take away heat, so the design of the heat sink may be quite different from the conventional heat sink used for sensible heat transfer. The mechanism of the heat sink for sensible heat transfer is use the temperature difference between the liquid in the contact part and the wall of the heat sink to achieve the effect of heat transfer. In the application of phase change heat transfer, it is necessary to change the phase of the liquid in contact with the wall surface to vaporize, and the vaporized gas leaves the wall surface, so that the supplemented immersion liquid can continuously contact the wall surface and vaporize to utilize the latent heat of vaporization to achieve the purpose of removing heat. However, the rate at which the immersion liquid vaporizes from the wall and leaves the wall is related to the wall temperature and the boiling point of the immersion liquid then, and this Twall - Tsaturated is generally referred to as the wall superheat.

To have higher heat transfer capacity under high heat flux, higher wall superheat is often required to meet the heat transfer requirement. However, higher wall superheats often lead the electronic device to be dissipated to have a temperature exceeding its tolerance temperature. In addition to the increase of the wall superheat, another way to improve the heat transfer capacity is to effectively generate an area of the vaporization region for phase change boiling. However, limited by the thermal diffusivity, the area where the wall superheat can be increased enough to produce significant phase change boiling is also considerably limited, so most of the extension connections are in areas with very low heat transfer efficiency for phase change and can only take away a little heat by the sensible heat transfer of the temperature difference, which does little help to the overall heat dissipation capacity.

### SUMMARY

The disclosure provides a heat sink with a novel structure.

The disclosure provides an electronic device with good heat dissipation effect.

A heat sink of the disclosure is adapted for dissipating heat from a heat source. The heat sink includes a heat dissipating plate and a cover plate. The heat dissipating plate has an inlet region, an outlet region and a vaporization region. The vaporization region is located between the inlet region and the outlet region, and the vaporization region is disposed corresponding to the heat source. The cover plate covers the heat dissipating plate. A space between the cover plate and the heat dissipating plate forms a channel with an inlet and an outlet. A cooling liquid flows into the channel from the inlet, the cooling liquid is heated and vaporized into gas when passing through the vaporization region, and the vaporized gas dissipates outside the channel through the outlet.

An electronic device of the disclosure includes a circuit board and the heat sink. The circuit board has a heat source. The heat sink contacts the heat source to dissipate heat from the heat source.

In an embodiment of the disclosure, microstructures are disposed on a surface of the vaporization region of the heat dissipating plate.

In an embodiment of the disclosure, the heat sink further includes at least one heat dissipation fin group disposed in at least one of the inlet region and the outlet region.

In an embodiment of the disclosure, heat dissipation fin groups are disposed in the inlet region and the outlet region, and a distance between heat dissipation fins of the heat dissipation fin group located in the inlet region is less than a distance between heat dissipation fins of the heat dissipation fin group located in the outlet region.

In an embodiment of the disclosure, a diameter of the inlet is less than a diameter of the outlet.

In an embodiment of the disclosure, the vaporization region is not on the same level as at least one of the inlet region and the outlet region.

In an embodiment of the disclosure, a first guide slope is disposed between the vaporization region and the inlet region, a second guide slope is disposed between the vaporization region and the outlet region, and an extension of the first guide slope intersects an extension of the second guide.

In an embodiment of the disclosure, the heat source is a graphics processing unit (GPU) or a central processing unit (CPU).

In summary, the disclosure provides a heat sink with a novel structure, which can effectively improve the heat dissipation effect, thereby prolonging the service life of the electronic device.

### BRIEF DESCRIPTION OF THE DRAWING

FIG. 1 is a schematic view of an electronic device according to an embodiment of the disclosure.
FIG. 2 is a schematic view of a heat dissipating plate and a heat dissipation fin group disposed on the heat dissipating plate.
FIG. 3 is a schematic view of a confined channel of a heat sink.
FIG. 4 is a schematic view of a heat sink according to another embodiment.

### DESCRIPTION OF THE EMBODIMENTS

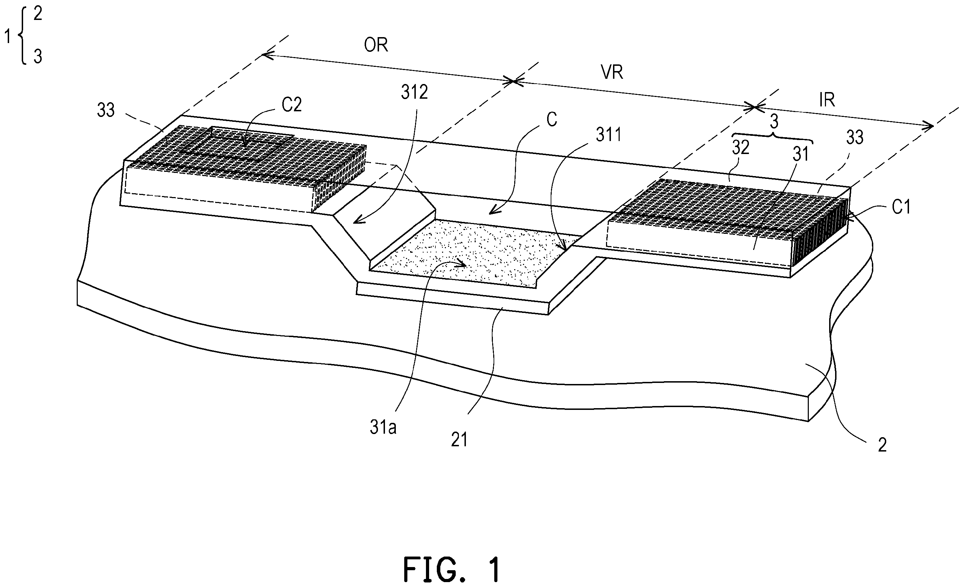

FIG. 1 is a partial schematic view of an electronic device according to an embodiment of the disclosure. Referring to FIG. 1, an electronic device 1 of the disclosure may be a host or a server of a desktop computer. The electronic device 1 includes a circuit board 2 and a heat sink 3. The circuit board 2 has a heat source 21, the heat source 21 may be a graphics processing unit (GPU) or a central processing unit (CPU), and the heat sink 3 in the embodiment is a two-phase immersion heat sink, and the heat sink 3 is used for contacting the heat source 21 to dissipate heat from the heat source 21.

As mentioned, the heat sink 3 includes a heat dissipating plate 31 and a cover plate 32. The heat dissipating plate 31 has an inlet region IR, an outlet region OR, and a vaporization region VR. The vaporization region VR is located between the inlet region IR and the outlet region OR, and the vaporization region VR is disposed corresponding to the heat source 21. The vaporization region VR of the heat sink 3 is disposed in contact with the heat source 21.

The cover plate 32 covers the heat dissipating plate 31, the space between the cover plate 32 and the heat dissipating plate 31 forms a channel C, and the channel C has an inlet C1 and an outlet C2. The inlet C1 is disposed in the inlet region IR, and the outlet C2 is correspondingly disposed in the outlet region OR. The cooling liquid passes through the inlet C1 of the channel C to enter the inlet region IR.

In the embodiment, the cover plate 32 covers the heat dissipating plate 31 to form the inlet C1, and the outlet C2 is disposed on the top surface of the cover plate 32. In another embodiment not shown, the outlet C2 may also be formed by covering the heat dissipating plate 31 through the cover plate 32, and the inlet C1 and the outlet C2 are located on opposite sides of the vaporization region VR.

When the electronic device 1 operates, the heat source 21 emits a large amount of heat. Meanwhile, the cooling liquid in the vaporization region VR in the channel C is vaporized into gas due to the heat of the heat source 21, and the vaporized gas flows through the outlet region OR and is discharged out of the heat sink 3 through the outlet C2.

Since the vaporized gas is dissipated to the outside of the channel C through the outlet C2, the pressure in the channel C changes, so that the cooling liquid can automatically flow into the channel C. That is, the cooling liquid may automatically and continuously fill into the channel C, so the heat sink 3 can dissipate the heat accumulated on the heat source 21, preventing the heat source 21 from being damaged due to overheating, thereby prolonging the service life of the electronic device 1.

As mentioned, in the embodiment, the diameter of the inlet C1 is less than the diameter of the outlet C2. With such a configuration, due to the large diameter of the outlet C2, the discharge of the vaporized cooling liquid can be accelerated, and the heat accumulated in the heat source 21 can be quickly removed, thereby improving the heat dissipation effect of the heat sink 3.

In addition, microstructures 31a are disposed on the surface of the vaporization region VR of the heat dissipating plate 31. The configuration of the microstructures 31a increases the surface roughness of the vaporization region VR, which contributes to the increase of the thermal foaming phenomenon of the cooling liquid in the vaporization region VR and enhance the vaporization effect.

Note that the heat sink 3 further includes a heat dissipation fin group 33, and the heat dissipation fin group 33 is disposed at least one of the inlet region IR and the outlet region OR. In the embodiment, both the inlet region IR and the outlet region OR are configured with the heat dissipation fin group 33. The configuration of the heat dissipation fin group 33 contributes to a further improvement of the heat dissipation effect of the heat sink 3.

In detail, the vaporization region VR of the heat sink 3 directly contacts the heat source 21, so the temperature of the region where the inlet region IR is closer to the vaporization region VR may also be closer to the temperature of the vaporization region VR. In other words, the temperature difference in the region of the inlet region IR adjacent to the vaporization region VR is small. However, the heat sink 3 of the embodiment can still achieve good heat dissipation efficiency under the conditions of low temperature difference and high heat flux.

Specifically, under the requirement of low temperature difference, it is difficult to increase the area of the vaporization region VR by extending the heat dissipating plate 31, and it is also difficult to increase the wall superheat to achieve a higher-capacity vaporization rate. However, the heat sink 3 of the present embodiment increases the convective heat in the region that is about to enter the inlet region IR of the vaporization region VR by configuring the heat dissipation fin group 33 with the improved effective heat dissipation area in the inlet region IR farther from the heat source 21. Compared with the conventional design in which a surface structure capable of improving the evaporation capacity is disposed on the entire surface of the vaporization surface of the heat dissipating plate 31, by which the overall convective heat transfer capacity still cannot be effectively improved, the heat dissipation fin group 33 in the embodiment can only be configured in the part of the inlet region IR relatively close to the vaporization region VR, so as to increase the temperature of the cooling liquid entering the vaporization region VR to be closer to the saturation temperature, so that it is easier to vaporize.

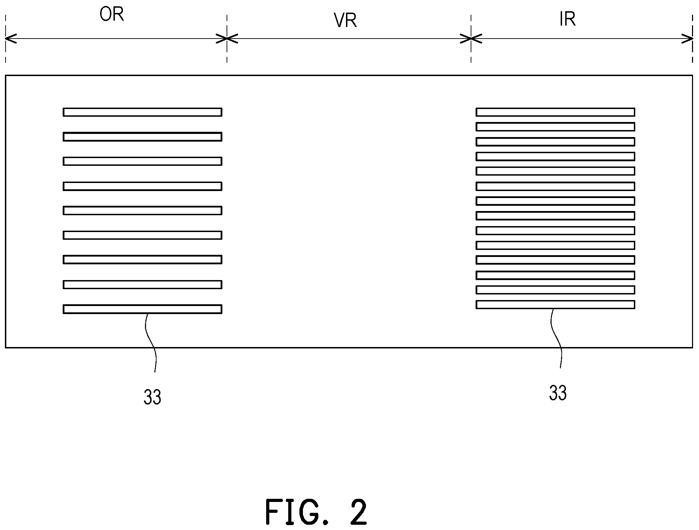

FIG. 2 is a schematic view of a heat dissipating plate and a heat dissipation fin group disposed on the heat dissipating plate. Referring to FIG. 2, in the embodiment, the distance between the heat dissipation fins of the heat dissipation fin group 33 in the inlet region IR is less than the distance between the heat dissipation fins of the heat dissipation fin group 33 in the outlet region OR.

In addition, the inlet C1 is located below the outlet C2, and the vaporized vapor passing through the vaporization region VR leaves the channel C from the outlet C2 through the fins of the heat dissipation fin group 33 of the outlet region OR due to the change in density. Meanwhile, the cooling liquid enters the channel C from the inlet C1. Although the temperature of the fins of the heat dissipation fin group 33 is not high enough for the cooling liquid to vaporize, the temperature may allow the cooling liquid to be heated to a temperature closer to the saturation temperature before the cooling liquid enters the vaporization region VR. The cooling liquid is easier to vaporize after entering the vaporization region VR.

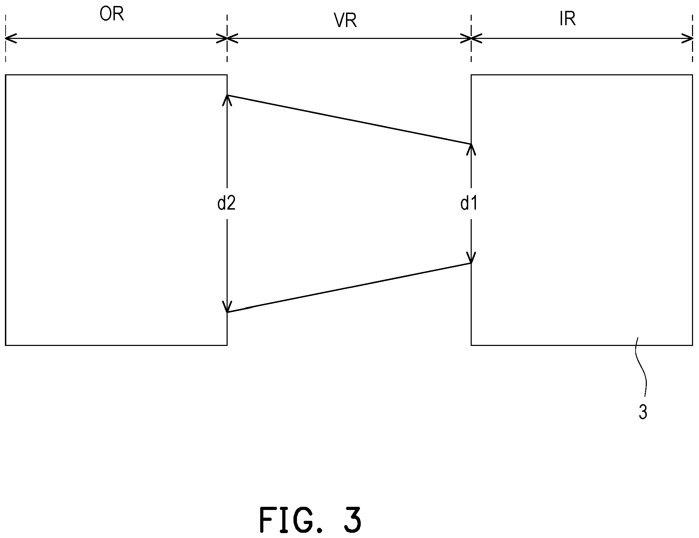

In addition, the vaporized gas can be designed to increase the flow rate of the vaporized gas flowing into the heat dissipation fin group 33 disposed in the outlet region OR through a confined channel design, in exchange for favorable heat exchange capacity. FIG. 3 is a schematic view of a confined channel of a heat sink. Referring to FIG. 3, the confined channel can be implemented by making the diameter of the connection between the vaporization region VR and the inlet region IR to be different from the diameter of the connection between the vaporization region VR and the outlet region OR. Specifically, the diameter d2 of the connection between the vaporization region VR and the outlet region OR is greater than the diameter d1 of the connection between the vaporization region VR and the inlet region IR.

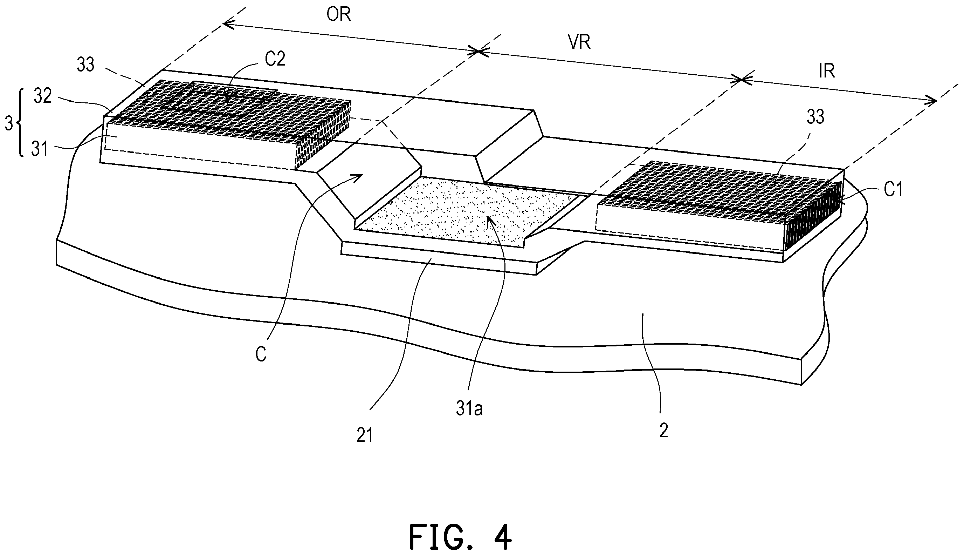

In addition, in the embodiment, at least one of the vaporization region VR, the inlet region IR, and the outlet region OR is not on the same level. Specifically, considering the configuration of other electronic components (not shown) on the circuit board 2, the configuration heights of the vaporization region VR, the inlet region IR and the outlet region OR can be changed to create an escape space to prevent the heat sink 3 from being in contact with other electronic components (not shown) on the circuit board 2. In the embodiment, the height of the vaporization region VR is less than the heights of the inlet region IR and the outlet region OR, and the inlet region IR and the outlet region OR have the same height. FIG. 4 is a schematic view of a heat sink according to another embodiment. In the embodiment of FIG. 4, the height of the inlet region IR may be less than the height of the outlet region OR, which is designed according to actual requirements.

Referring to FIG. 1 again, when the height of the vaporization region VR is less than the heights of the inlet region IR and the outlet region OR. A first guide slope 311 can be disposed between the vaporization region VR and the inlet region IR, and a second guide slope 312 is disposed between the vaporization region VR and the outlet region OR, and the extension of the first guide slope 311 intersects the extension of the second guide slope 312. The configuration of the first guide slope 311 and the second guide slope 312 contributes to the fluid (vaporized gas and cooling liquid) to flow relatively quickly along the first guide slope 311 and the second guide slope 312, thereby improving the overall heat dissipation effect of the heat sink 3.

In more detail, when the cooling liquid flows into the vaporizing region VR from the inlet region IR through the first guide slope 311, the cooling liquid may impact the plane of the vaporizing region VR, thereby causing the phenomenon of thermal foaming more quickly.

The cooling liquid used in the embodiment may be a liquid with a low boiling point under normal pressure or a dielectric liquid, and the boiling point of the cooling liquid is, for example, between 49 degrees and 56 degrees.

In summary, the disclosure provides a heat sink with a novel structure. Compared with the conventional heat sink, the heat sink of the disclosure can more effectively improve the vaporization efficiency, accelerate the heat dissipation rate, and prolong the service life of the electronic device with the heat sink due to the change of the structure.
1: electronic device
2: circuit board
3: heat sink
21: heat source
31: heat dissipating plate
31a: microstructure
311 : first guide slope
312 : second guide slope
32: cover plate
3 3: fin group
IR: inlet region
OR: outlet region
VR: vaporization region
C: channel
C1: inlet
C2: outlet
d1, d2: diameter

## Claims

1. A heat sink (3), adapted for dissipating heat from a heat source (21), wherein the heat sink (3) comprises:
a heat dissipating plate (31), comprising an inlet region (IR), an outlet region (OR) and a vaporization region (VR), wherein the vaporization region (VR) is located between the inlet region (IR) and the outlet region (OR), and the vaporization region (VR) is disposed corresponding to the heat source (21); and
a cover plate (32), covering the heat dissipating plate (31), wherein a space between the cover plate (32) and the heat dissipating plate (31) forms a channel (C) with an inlet (C1) and an outlet (C2),
wherein a cooling liquid flows into the channel (C) from the inlet (C1), the cooling liquid is heated and vaporized into gas when passing through the vaporization region (VR), and the vaporized gas dissipates outside the channel (C) through the outlet (C2).

2. The heat sink (3) of claim 1, wherein microstructures (31a) are disposed on a surface of the vaporization region (VR) of the heat dissipating plate (31).

3. The heat sink (3) of claim 1, further comprising at least one heat dissipation fin group (33) disposed in at least one of the inlet region (IR) and the outlet region (OR).

4. The heat sink (3) of claim 1, wherein heat dissipation fin groups (33) are disposed in the inlet region (IR) and the outlet region (OR), and a distance between heat dissipation fins of the heat dissipation fin group (33) located in the inlet region (IR) is less than a distance between heat dissipation fins of the heat dissipation fin group (33) located in the outlet region (OR).

5. The heat sink (3) of claim 1, wherein a diameter (d1) of the inlet (C1) is less than a diameter (d2) of the outlet (C2).

6. The heat sink (3) of claim 1, wherein the vaporization region (VR) is not on the same level as at least one of the inlet region (IR) and the outlet region (OR).

7. The heat sink (3) of claim 6, wherein a first guide slope (311) is disposed between the vaporization region (VR) and the inlet region (IR), a second guide slope (312) is disposed between the vaporization region (VR) and the outlet region (OR), and an extension of the first guide slope (311) intersects an extension of the second guide.

8. An electronic device (1), comprising:
a circuit board (2) with a heat source (21);
a heat sink (3), contacting the heat source (21) to dissipate heat from the heat source (21), wherein the heat sink (3) comprises:
a heat dissipating plate (31), comprising an inlet region (IR), an outlet region (OR) and a vaporization region (VR), wherein the vaporization region (VR) is located between the inlet region (IR) and the outlet region (OR), and the vaporization region (VR) is disposed corresponding to the heat source (21); and
a cover plate (32), covering the heat dissipating plate (31), wherein a space between the cover plate (32) and the heat dissipating plate (31) forms a channel (C) with an inlet (C1) and an outlet (C2),
wherein a cooling liquid flows into the channel (C) from the inlet (C1), the cooling liquid is heated and vaporized into gas when passing through the vaporization region (VR), and the vaporized gas dissipates outside the channel (C) through the outlet (C2).

9. The electronic device (1) of claim 8, wherein microstructures (31a) are disposed on a surface of the vaporization region (VR) of the heat dissipating plate (31).

10. The electronic device (1) of claim 8, wherein the heat sink (3) further comprises at least one heat dissipation fin group (33) disposed in at least one of the inlet region (IR) and the outlet region (OR).

11. The electronic device (1) of claim 8, wherein heat dissipation fin group (33)s are disposed in the inlet region (IR) and the outlet region (OR), and a distance between heat dissipation fins of the heat dissipation fin group (33) located in the inlet region (IR) is less than a distance between heat dissipation fins of the heat dissipation fin group (33) located in the outlet region (OR).

12. The electronic device (1) of claim 8, wherein a diameter of the inlet (C1) is less than a diameter of the outlet (C2).

13. The electronic device (1) of claim 8, wherein the vaporization region (VR) is not on the same level as at least one of the inlet region (IR) and the outlet region (OR).

14. The electronic device (1) of claim 13, wherein a first guide slope (311) is disposed between the vaporization region (VR) and the inlet region (IR), a second guide slope (312) is disposed between the vaporization region (VR) and the outlet region (OR), and an extension of the first guide slope (311) intersects an extension of the second guide.

15. The electronic device (1) of claim 8, wherein the heat source (21) is a graphics processing unit (GPU) or a central processing unit (CPU).
